(19) Europäisches Patentamt
European Patent Office
Office européen des brevets

(11) EP 0 884 645 B1

(12) **EUROPEAN PATENT SPECIFICATION**

(45) Date of publication and mention of the grant of the patent:
**27.12.2000 Bulletin 2000/52**

(51) Int Cl.[7]: **G03F 3/10**, G03F 7/07

(21) Application number: **97201687.7**

(22) Date of filing: **09.06.1997**

(54) **Method for verifying silver-based lithographic printing plates**

Verfahren zur Überprüfung von auf Silber basierenden Flachdruckplatten

Procédé de vérification d'une plaque d'impression lithographique à base d'argent

(84) Designated Contracting States:
**BE DE FR GB**

(43) Date of publication of application:
**16.12.1998 Bulletin 1998/51**

(73) Proprietor: **AGFA-GEVAERT N.V.**
**2640 Mortsel (BE)**

(72) Inventor: **Deprez, Lode**
**2640 Mortsel (BE)**

(56) References cited:
**EP-A- 0 736 808** **US-A- 5 283 157**

- **PATENT ABSTRACTS OF JAPAN vol. 012, no. 354 (P-761), 22 September 1988 & JP 63 106660 A (MITSUBISHI PAPER MILLS LTD), 11 May 1988,**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 884 645 B1

## Description

### FIELD OF THE INVENTION

The present invention relates to a method for verifying the quality of silver-based lithographic printing plates by matching the colour of the silver image with a colour reference system.

### BACKGROUND OF THE INVENTION

A preferred method of lithographic plate-making uses the so-called direct-to-plate systems which allow the direct exposure of the plate precursor instead of having to use a film intermediate as exposure mask. Materials that work according to the diffusion transfer reversal (DTR) process are highly preferred direct-to-plate systems since their high-speed and positive-working imaging process offers the high versatility of being exposed by projection camera's directly from the paste-up copy as well as by most commonly available laser image-setters currently used in graphic arts applications.

The principles of the DTR process have been described e.g. in US-P-2,352,014 and in the book "Photographic Silver Halide Diffusion Processes" by André Rott and Edith Weyde - The Focal Press - London and New York, (1972). By DTR processing of an information-wise exposed silver halide material, non-developed silver halide present in the photosensitive emulsion layer of the material is transformed with a so-called silver halide solvent into soluble silver complex compounds which are allowed to diffuse into an image receiving element and are reduced therein with a developing agent, generally in the presence of physical development nuclei, to form a positive silver image having reversed image density values ("DTR image") with respect to the negative black silver image obtained in the exposed areas of the photographic material. In a preferred embodiment, said image receiving element is present in the same material as the photosensitive layer, thereby forming a so-called mono-sheet DTR material, though two-sheets embodiments are also known in the art.

Before processing, a typical DTR lithographic printing plate precursor is characterised by a hydrophilic surface, being water-receptive and non-wettable by ink. After processing, the silver particles that are formed in the image receiving layer at the unexposed areas are hydrophobic (oleophilic) and their ink-receptivity is further enhanced by hydrophobising agents which are present in the processing liquid(s) so as to form an ink-receptive silver image at the printing areas of the plate.

The printing quality of the lithographic printing plate obtained after processing may be influenced by multiple parameters, e.g. the manufacturing process of the printing plate precursor and of the processing liquids, storage conditions of said precursor and liquids, processing parameters such as temperature, exhaustion of processing liquids due to evaporation, oxidation or non-optimal replenishment, maintenance of the processing apparatus, etc. Once the lithographic printing plate is obtained, its printing quality can not be adjusted anymore and a poor quality can only be remedied by making another plate. It would be advantageous to have a method for verifying the printing quality of the plate before starting the printing job. An even more preferred method should also provide information about the cause of a non-optimal quality by indicating the appropriate adjustments of the plate-making method in an effective and convenient way.

### SUMMARY OF THE INVENTION

It is therefore a first object of the present invention to provide a method for verifying the printing quality of a lithographic printing plate which is obtained by a plate-making process whereby an ink-receptive silver image is formed at the printing areas. This object is realised by a method comprising the step of matching the colour of the silver image of said plate with a plurality of reference colours contained in a colour reference system that provides information regarding the quality of silver-based lithographic printing plates having said reference colours.

The above mentioned method is a convenient and elegant solution relying on the surprising result of the inventor's research that the printing quality of a silver-based printing plate is correlated with the colour of the silver image at the printing areas. In a preferred embodiment, the colour reference system also provides information regarding the parameter(s) of the plate-making process that need to be adjusted in order to optimize the printing quality of the plate obtained by said plate-making process.

It is another object of the present invention to provide a method for obtaining the above mentioned colour reference system for verifying the printing quality of a lithographic printing plate. This object is realised by a method comprising the step of quantifying the silver image colour of a plurality of reference plates in terms of device-independent colour data. In a preferred embodiment, the colour reference system reproduces the reference colours by means of a colour output device of which the colour output signal values are obtained by transforming said device-independent colour data in such a way that the reproduced colours match the reference colours accurately.

Further objects and advantages of the invention will become apparent from the description hereinafter.
Preferred embodiments of the invention are disclosed in the dependent claims.

DETAILED DESCRIPTION OF THE INVENTION

The specification "silver-based lithographic printing plate" as used herein means a printing plate, obtained by a plate-making process whereby an ink-receptive silver image is formed at the printing areas. As described above, a highly preferred plate-making method in accordance with the present invention is the silver salt diffusion transfer reversal (DTR) process which typically comprises the steps of image-wise exposing a DTR imaging element, the so-called printing plate precursor, and then treating said exposed element with (a) processing liquid(s).
The DTR image can be formed in the image receiving layer of a separate element with respect to the photographic silver halide emulsion material (a so-called two-sheet DTR element) or in the image receiving layer of a so-called single-support element, also called mono-sheet element, which contains at least one photographic silver halide emulsion layer as well as an image receiving layer in water-permeable relationship therewith. It is the latter mono-sheet type which is preferred for the preparation of offset printing plates by the DTR method.
Before dealing with the method claimed by the present invention, two preferred embodiments of an imaging element that may be used as a mono-sheet DTR offset printing plate precursor will be described hereinafter. According to a first type, disclosed in e.g. US-P 4,722,535 and GB 1,241,661, an imaging element is provided comprising a support and coated thereon in the order given a silver halide emulsion layer and an image receiving layer containing physical development nuclei in water permeable relationship with said emulsion layer. Layers being in water-permeable contact with each other are hydrophilic layers that are contiguous to each other or only separated from each other by (a) water-permeable layer(s). The nature of a water-permeable layer is such that it does not substantially inhibit or restrain the diffusion of water or of compounds contained in an aqueous solution e.g. developing agents or complexed silver ions.
Supports suitable for use in said imaging elements may be opaque or transparent, e.g. a paper support or resin support. When a paper support is used, preference is given to one coated at one or both sides with an alpha-olefin polymer, e.g. a polyethylene layer which optionally contains an anti-halation dye or pigment. It is also possible to use an organic resin support e.g. cellulose nitrate film, cellulose acetate film, polyvinylacetal film, polystyrene film, polyethyleneterephthalate film, polycarbonate film, polyvinylchloride film or poly-$\alpha$-olefin films such as polyethylene or polypropylene film. The thickness of such organic resin film is preferably comprised between 0.07 and 0.35 mm. These organic resin supports are preferably coated with a hydrophilic adhesion layer which can contain water insoluble particles such as silica or titanium dioxide. Metal supports e.g. aluminium may also be used.
The photographic silver halide emulsion can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al. in "Making and Coating Photographic Emulsion", The Focal Press, London (1966). The emulsion preferably consists essentially or totally of silver chloride while a fraction of silver bromide may be present ranging from 0.1 molar% to 40 molar%. When the fraction of silver bromide is 5% or more, the emulsion preferably belongs to the core/shell type well known to those skilled in the art in the sense that substantially all the bromide is concentrated in the core. This core contains preferably 10 to 40% of the total silver halide precipitated, while the shell consists preferably of 60 to 90% of the total silver halide precipitated. The average size of the silver halide grains may range from 0.10 to 0.70 $\mu$m , preferably from 0.25 to 0.45 $\mu$m. Preferably during the precipitation stage Iridium and/or Rhodium containing compounds or a mixture of both are added. The concentration of these added compounds ranges from $10^{-8}$ to $10^{-3}$ mole per mole of $AgNO_3$, preferably between $0.5x10^{-7}$ and $10^{-5}$ mole per mole of $AgNO_3$.
The silver halide emulsion may be chemically sensitised according to the procedures described in e.g. "Chimie et Physique Photographique" by P. Glafkides, in "Photographic Emulsion Chemistry" by G.F. Duffin, in "Making and Coating Photographic Emulsion" by V.L. Zelikman et al, and in "Die Grundlagen der Photographischen Prozesse mit Silberhalogeniden" edited by H. Frieser and published by Akademische Verlagsgesellschaft (1968). As described in said literature chemical sensitisation can be carried out by effecting the ripening in the presence of small amounts of compounds containing sulphur, selenium or tellurium e.g. thiosulphate, thiocyanate, thiourea, selenosulphate, selenocyanate, selenoureas, tellurosulphate, tellurocyanate, sulphites, mercapto compounds, and rhodamines. In a preferred embodiment, these compounds are applied in combination with a noble metal salt, preferably a gold complex salt, but also salts of platinum, palladium and iridium as described in U.S. Patent No. 2,448,060 and British Patent No. 618,061 may be used. Additions of sulphur and/or selenium and/or tellurium and gold may be carried out consecutively or simultaneously. In the latter case the addition of gold thiosulphate, gold selenosulphate or gold tellurosulphate compounds may be recommended. Optionally, small amounts of compounds of Rh, Ru, Pb, Cd, Hg, or Tl can be added. Also reducing agents may be added as chemically sensitising agents, e.g. tin compounds as described in British Patent No. 789 823, amines, hydrazine derivatives, formamidine-sulphinic acids, and silane compounds. The chemical sensitisation can also proceed in the presence of phenidone and/or its derivatives, a dihydroxybenzene as hydroquinone, resorcinol, catechol and/or a derivative(s) thereof, one or more stabiliser(s) or antifoggant(s), one or more spectral sensitiser(s) or combinations of said ingredients.

The silver halide emulsion of the DTR element can be spectrally sensitised according to the spectral emission of the exposure source for which the DTR element is designed. Suitable sensitising dyes for the visible spectral region include methine dyes such as those described by F.M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes. In the case of a conventional light source, e.g. tungsten light, a green sensitising dye is needed. In case of exposure by an argon ion laser a blue sensitising dye is incorporated. In case of exposure by a red light emitting source, e.g. a LED or a He/Ne laser, a red sensitising dye is used. In case of exposure by a semiconductor laser special spectral sensitising dyes suited for the near infra-red are required. Suitable infra-red sensitising dyes are disclosed in i.a. US-P 2,095,854, 2,095,856, 2,955,939, 3,482,978, 3,552,974, 3,573,921, 3,582,344, 3,623,881 and 3,695,888. A preferred blue sensitising dye, green sensitising dye, red sensitising dye and infra-red sensitising dye are described in EP-A 554,585.

To enhance the sensitivity in the red or near infra-red region use can be made of so-called supersensitisers in combination with red or infra-red sensitising dyes. Suitable supersensitisers are described in Research Disclosure Vol. 289, May 1988, item 28952. The spectral sensitises can be added to the silver halide emulsion in the form of an aqueous solution, a solution in an organic solvent or in the form of a dispersion.

The silver halide emulsion may contain the usual stabilisers. Suitable emulsion stabilisers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable emulsion stabilisers are i.a. heterocyclic mercapto compounds.

The silver halide emulsion may contain pH controlling ingredients. Preferably the emulsion layer is coated at a pH value near the isoelectric point of the gelatin to improve the stability characteristics of the coated layer. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

More details about the composition, preparation and coating of silver halide emulsions can be found in e.g. Product Licensing Index, Vol. 92, December 1971, publication 9232, p. 107-109.

The image receiving layer can be free of hydrophilic binder but preferably comprises a hydrophilic amphoteric block copolymer as used in the present invention. Besides said block copolymer, the image receiving layer may contain other hydrophilic colloids such as polyvinyl alcohol up to an amount of about 80% by weight of the total weight of said layer. Other suitable hydrophilic polymer binders have been disclosed in e.g. US-P 3,728,114; 4,160,670; 4,606,985; 4,510,228; 4,743,525; 4,879,193; 5,153,097; 5,108,871; 5,041,354. EP-A-715,211 and 751,429 disclose an image receiving layer comprising a colloidal clay in order to improve the lithographic properties of DTR plates.

The image receiving layer further contains physical development nuclei. Preferred physical development nuclei are sulphides of heavy metals e.g. sulphides of antimony, bismuth, cadmium, cobalt, lead, nickel, palladium, platinum, silver, and zinc. Especially suitable development nuclei are palladium sulphide nuclei. Other suitable development nuclei are heavy metal salts such as e.g. selenides, polyselenides, polysulphides, mercaptans, and tin (II) halides. Heavy metals, preferably silver, gold, platinum, palladium, and mercury can be used in colloidal form. As disclosed in EP-A-546,598 the physical development nuclei preferably have a narrow size distribution.

Between the support and the silver halide emulsion layer there is preferably provided a base layer that preferably contains an anti-halation substance such as e.g. light-absorbing dyes absorbing the light used for image-wise exposure of the imaging element. As alternative finely divided carbon black can be used as an anti-halation substance. On the other hand, in order to gain sensitivity, light reflecting pigments, e.g. titanium dioxide can be present in the base layer. This layer can further contain hardening agents, matting agents, e.g. silica particles, and wetting agents. Suitable matting agents preferably have an average diameter of 2 to 10 µm and more preferably between 2 µm and 5 µm. The matting agents are generally used in a total amount in the imaging element of 0.1 g/m$^2$ to 2.5 g/m$^2$. At least part of these matting agents and/or light reflection pigments may also be present in the silver halide emulsion layer and/or in the cover layer. As a further alternative the light reflecting pigments may be present in a separate layer provided between the anti-halation layer and the photosensitive silver halide emulsion layer. Like the emulsion layer the base layer is coated preferably at a pH value near the isoelectric point of the gelatin in the base layer.

In the present embodiment a backing layer preferably is provided at the non-light sensitive side of the support. This layer which can serve as anti-curl layer can contain i.a. matting agents e.g. silica particles, lubricants, anti-static agents, light absorbing dyes, opacifying agents, e.g. titanium oxide and the usual ingredients like hardeners and wetting

agents. The backing layer can consist of one single layer or a double layer pack.

The hydrophilic layers usually contain gelatin as hydrophilic colloid binder. Mixtures of different gelatines with different viscosity can be used to adjust the rheological properties of the layer. Like the emulsion layer the other hydrophilic layers are coated preferably at a pH value near the isoelectric point of the gelatin. But instead of or together with gelatin, one or more other natural and/or synthetic hydrophilic colloids may be used, e.g. albumin, casein, zein, polyvinyl alcohol, alginic acids or salts thereof, cellulose derivatives such as carboxymethyl cellulose, and modified gelatin such as phthaloyl gelatin.

The hydrophilic layers of the imaging element, especially when the binder used is gelatin, can be hardened with appropriate hardening agents such as those of the vinylsulphone type e.g. methylenebis(sulphonylethylene), aldehydes e.g. formaldehyde, glyoxal, and glutaraldehyde, N-methylol compounds e.g. dimethylolurea and methyloldimethylhydantoin, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

Preferably used hardening agents are of the aldehyde type. The hardening agents can be used in a wide concentration range but are preferably used in an amount of 4% to 7% of the hydrophilic colloid. Different amounts of hardener can be used in the different layers of the imaging element or the hardening of one layer may be adjusted by the diffusion of a hardener from another layer.

The imaging element according to the present embodiment may further comprise various kinds of surface-active agents in the silver halide emulsion layer or in at least one other hydrophilic colloid layer. Examples of suitable surface-active agents are described in e.g. EP 545452. Preferably compounds containing perfluorinated alkyl groups are used. The imaging element of the present embodiment may further comprise various other additives such as e.g. compounds improving the dimensional stability of the imaging element, UV-absorbers, spacing agents and plasticisers.

Suitable additives for improving the dimensional stability of the imaging element are e.g. dispersions of a water-soluble or hardly soluble synthetic polymer e.g. polymers of alkyl (meth)acrylates, alkoxy(meth)acrylates, glycidyl (meth)acrylates, (meth)acrylamides, vinyl esters, acrylonitriles, olefins, and styrenes, or copolymers of the above with acrylic acids, methacrylic acids, alpha-beta-unsaturated dicarboxylic acids, hydroxyalkyl (meth)acrylates, sulphoalkyl (meth)acrylates, and styrene sulphonic acids.

The imaging element can be information-wise exposed in an apparatus using a camera-exposure or a scanning exposure according to its particular application. A wide choice of cameras for exposing the photosensitive silver halide emulsion exists on the market. Horizontal, vertical and darkroom type cameras and contact-exposure apparatus are available to suit any particular class of reprographic work. The imaging element can also be exposed with the aid of cathode rays tubes and laser recorders or laser image-setters. The laser sources used comprise e.g. He/Ne or Ar gas lasers and red or infrared semiconductor lasers emitting in the wavelength range from 600 to 1500 nm.

The processing liquid used for developing the DTR imaging element are alkaline solutions which contain a silver halide solvent. Preferably the silver halide solvent is used in an amount between 0.01% by weight and 10% by weight and more preferably between 0.05% by weight and 8% by weight. Suitable silver halide solvents are e.g. 2-mercaptobenzoic acid, cyclic imides, oxazolidones and thiosulphates. Preferred silver halide solvents are thiocyanates and alkanolamines. Preferred alkanolamines are of the tertiary, secondary or primary type corresponding to the following formula:

$$\begin{array}{l} C_lH_{2l}\text{-}X \\ | \\ N\text{-}C_mH_{2m}\text{-}X' \\ | \\ C_nH_{2n}\text{-}OH \end{array}$$

wherein X and X' independently represent hydrogen, a hydroxyl group or an amino group, l and m represent 0 or integers of 1 or more and n represents an integer of 1 or more. Preferably used alkanolamines are e.g. N-(2-aminoethyl) ethanolamine, diethanolamine, N-methylethanolamine, triethanolamine, N-ethyldiethanolamine, diisopropanolamine, ethanolamine, 4-aminobutanol, N,N-dimethylethanolamine, 3-aminopropanol, N,N-ethyl-2,2'-iminodiethanol, etc. or mixtures thereof. The alkanolamines are preferably present in the alkaline processing liquid. However part or all of the alkanolamine can be present in one or more layers of the imaging element.

A further suitable type of silver halide solvents are thioether compounds. Preferably used thioethers correspond to the following general formula:

$$Z\text{-}(R^1\text{-}S)_t\text{-}R^2\text{-}S\text{-}R^3\text{-}Y$$

wherein Z and Y each independently represents hydrogen, an alkyl group, an amino group, an ammonium group, a hydroxyl, a sulpho group, a carboxyl, an aminocarbonyl or an aminosulphonyl, $R^1$, $R^2$ and $R^3$ each independently represents an alkylene that may be substituted and optionally contain an oxygen bridge and t represents an integer from 0 to 10. Examples of thioether compounds corresponding to the above formula are disclosed in e.g. US-P-4,960,683 and EP-A 547,662.

Still further suitable silver halide solvents are meso-ionic compounds. Preferred meso-ionic compounds are triazolium thiolates and more preferred 1,2,4-triazolium-3-thiolates. Preferably at least part and more preferably all of the meso-ionic compound is present in the alkaline processing liquid used for developing the image-wise exposed imaging element. Preferably the amount of meso-ionic compound in the alkaline processing liquid is between 0.1 mmol/l and 25 mmol/l and more preferably between 0.5 mmol/l and 15 mmol/l and most preferably between 1 mmol/l and 8 mmol/l. However the meso-ionic compound may be incorporated in one or more layers comprised on the support of the imaging element. The meso-ionic compound is in that case preferably contained in the imaging element in a total amount between 0.1 and 10 mmol/$m^2$, more preferably between 0.1 and 5 mmol/$m^2$ and most preferably between 0.5 and 1.5 mmol/$m^2$. More details are disclosed in EP-A-0,554,585.

The alkaline processing liquid preferably has a pH between 9 and 14 and more preferably between 10 and 13. Said pH may be established by an organic or inorganic alkaline substance or a combination thereof. Suitable inorganic alkaline substances are e.g. potassium or sodium hydroxide, carbonate, phosphate etc. Suitable organic alkaline substances are e.g. alkanolamines. In the latter case the alkanolamines will provide or help maintain the pH and serve as a silver halide complexing agent.

The alkaline processing liquid may also contain (a) developing agent(s). In that case the processing liquid is called a developer. In another embodiment, some or all of the developing agent(s) may be present in one or more layers of the imaging element. When all of the developing agents are contained in the imaging element the processing liquid is called an activator or activating liquid. Silver halide developing agents are preferably of the p-dihydroxybenzene type, e.g. hydroquinone, methyl-hydroquinone or chloro-hydroquinone, preferably in combination with an auxiliary developing agent being a 1-phenyl-3-pyrazolidone type developing agent and/or p-monomethylaminophenol. Particularly useful auxiliary developing agents are the 1-phenyl-3-pyrazolidones. Even more preferred, particularly when they are incorporated into the imaging element are 1-phenyl-3-pyrazolidones of which the aqueous solubility is increased by a hydrophilic substituent such as e.g. hydroxy, amino, carboxylic acid group, sulphonic acid group etc. Examples of 1-phenyl-3-pyrazolidones substituted with one or more hydrophilic groups are e.g. 1-phenyl-4,4-dimethyl-2-hydroxy-3-pyrazolidone, 1-(4-carboxyphenyl)-4,4-dimethyl-3-pyrazolidone etc. However other developing agents can be used. At least the auxiliary developing agents are preferably incorporated into the imaging element, preferably in the silver halide emulsion layer of the imaging element, in an amount of less than 150 mg/g of silver halide expressed as $AgNO_3$, more preferably in an amount of less than 100 mg/g of silver halide expressed as $AgNO_3$.

The alkaline processing liquid used for developing an imaging element may also contain hydrophobising agents for improving the hydrophobicity of the silver image obtained in the image receiving layer. The hydrophobising agents are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Examples of hydrophobising agents are those described in US-P 3,776,728 and 4,563,410.

The hydrophobising agents preferably are contained in the alkaline processing liquid in an amount of at least 0.1 g/l, more preferably at least 0.2 g/l and most preferably at least 0.3 g/l. The maximum amount of hydrophobising agents will be determined by the type of hydrophobising agent, type and amount of silver halide solvents etc. Typically the concentration of hydrophobising agent is preferably not more than 1.5 g/l and more preferably not more than 1 g/l.

The alkaline processing liquid preferably also contains a preserving agent having anti-oxidation activity, e.g. sulphite ions provided e.g. by sodium or potassium sulphite. For example, the aqueous solution comprises sodium sulphite in an amount ranging from 0.15 to 1.0 mole/l. The alkaline processing liquid may further contain a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners. It is furthermore preferred to add a spreading agent or surfactant in order to assure equal spreading of the alkaline processing liquid over the surface of the imaging element. Such a surfactant should be stable at the pH of the alkaline processing liquid and should assure a fast overall wetting of the surface of the imaging element. A surfactant suitable for such purpose is e.g. a fluorine containing surfactant such as e.g. $C_7F_{15}COONH_4$. It is furthermore advantageous to add glycerine to the alkaline processing liquid so as to prevent crystallisation of dissolved components. Development acceleration can be accomplished by addition of various compounds to the alkaline processing liquid and/or one or more layers of the imaging element, preferably polyalkylene

derivatives having a molecular weight of at least 400 such as those described in e.g. US-P 3,038,805; 4,038,075; 4,292,400 and 4,975,354.

Subsequent to the development in an alkaline processing liquid, the surface of the printing plate is preferably neutralised using a neutralisation liquid, which is also called a stabiliser or stabilising liquid. A neutralisation liquid generally has a pH between 5 and 8. The neutralisation liquid preferably contains a buffer e.g. a phosphate buffer, a citrate buffer or mixture thereof. The neutralisation liquid can further contain bactericides, substances which influence the ink/water balance of the printing plate obtained after processing of the DTR element, e.g. hydrophobising agents as described above, silica and wetting agents, preferably compounds containing perfluorinated alkyl groups.

After the neutralisation step, the imaging element may optionally be rinsed with water. The rinsing water may comprise additives such as surface active ingredients or compounds which prevent growth of algae. After drying, a first embodiment of a lithographic plate which works according to the DTR mechanism is thus obtained.

According to another embodiment a lithographic printing plate can be obtained by means of the DTR process using an imaging element comprising in the order given a hydrophilic surface of a support, a layer containing physical development nuclei and a silver halide emulsion layer. Said hydrophilic surface of a support can be a hardened hydrophilic layer, containing a hydrophilic binder and a hardening agent coated on a flexible support, e.g. a paper support or a resin support as described above.

Such hydrophilic binders are disclosed in e.g. EP-A 450,199. Preferred hardened hydrophilic layers comprise partially modified dextrans or pullulan hardened with an aldehyde as disclosed in e.g. EP-A 514,990. More preferred hydrophilic layers are layers of polyvinyl alcohol hardened with a tetra-alkyl orthosilicate and preferably containing $SiO_2$ and/or $TiO_2$ wherein the weight ratio between said polyvinylalcohol and said tetra-alkyl orthosilicate is between 0.5 and 5 as disclosed in e.g. GB-P 1,419,512, FR-P 2,300,354, US-P-3,971,660, US-P 4,284,705, EP-A 405,016 and EP-A 450,199.

Said hydrophilic surface of a support can also be a hydrophilic metallic support e.g. an aluminium foil. The aluminium support of the imaging element for use in accordance with the present embodiment can be made of pure aluminium or of an aluminium alloy, the aluminium content of which is at least 95%. The thickness of the support usually ranges from about 0.13 to about 0.50 mm. The preparation of aluminium or aluminium alloy foils for lithographic printing comprises the following steps : graining, anodising, and optionally sealing of the foil. Graining and anodisation of the foil are necessary to obtain a lithographic printing plate that allows to produce high-quality prints. Sealing is not necessary but may still improve the printing results. Preferably the aluminium foil has a roughness with a CLA value between 0.2 and 1.5 µm, an anodisation layer with a thickness between 0.4 and 2.0 µm and is sealed with an aqueous bicarbonate solution. More details on the preparation of a grained, anodised and sealed aluminium foil are given in US-P 3,861,917 and in the documents referred to therein.

To promote the image sharpness and, as a consequence thereof, the sharpness of the final printed copy, the anodisation layer may be coloured in the mass with an anti-halation dye or pigment e.g. as described in JP-Pu-58,014,797.

The silver halide emulsion and the physical development nuclei are characterised by the same features as described above. As binder in the silver halide emulsion layer(s) a hydrophilic colloid may be used, usually a protein, preferably gelatin. Gelatin can, however, be replaced in part or integrally by synthetic, semi-synthetic, or natural polymers. Preferably the silver halide emulsion layer contains at least one gelatin species whereof a 10% by weight aqueous solution at 36°C and pH 6 has a viscosity lower than 20 mPas at a shearing rate of 1000 $s^{-1}$ combined with a gelatin of a higher viscosity. The weight ratio of said low viscosity gelatin versus the gelatin of a higher viscosity is preferably > 0.5.

Preferably the gelatin layer(s) is(are) substantially unhardened. Substantially unhardened means that when such gelatin layer is coated on a subbed polyethylene terephthalate film base at a dry thickness of 1.2 $g/m^2$, dried for 3 days at 57°C and 35% R.H. and dipped in water of 30°C, said gelatin layer is dissolved for more than 95% by weight within 5 minutes.

The imaging element of the present embodiment may be image-wise exposed using a camera or a scanning exposure as described above followed by a development step in the presence of development agent(s) and silver halide solvent(s) as described above so that a silver image is formed in the physical development nuclei layer. Subsequently the silver halide emulsion layer and any other optional hydrophilic layers are removed by e.g. rinsing the imaged element with water, preferably having a temperature between 30°C and 50°C so that the silver image is exposed.

To facilitate the removal of the silver halide emulsion layer it is advantageous to provide a layer between the layer containing physical development nuclei and the silver halide emulsion layer comprising a hydrophilic non-proteinic film-forming polymer e.g. polyvinyl alcohol, polymer beads e.g. poly(meth)acrylate beads, particles of a water insoluble inorganic compound having a number average size not lower than 0.1 µm, alkali insoluble non-polymeric organic compounds having a melting point of at least 50°C and a number average size between 0.1 and 10 µm and particles of an alkali insoluble polymer obtainable by polycondensation with a number average size between 0.02 and 10 µm.

Such type of layers are disclosed in EP-A-483415, EP-A-410500, EP-A-723195, EP-A-750227 and EP-A-773,474.

Finally the imaging element is treated with a composition often called finisher, which comprises at least one compound enhancing the ink-receptivity and/or lacquer-receptivity of the silver image and at least one compound that improves the ink-repelling characteristics of the hydrophilic surface. Suitable ingredients for the finisher are e.g. organic compounds containing a mercapto group such as the hydrophobising compounds referred to hereinbefore for the alkaline processing liquid. Said (a) hydrophobising agent(s) is(are) comprised in the finisher preferably in a total concentration between 0.1 g/l and 10 g/l, more preferably in a total concentration between 0.3 g/l and 3 g/l.

Additives improving the oleophilic ink-repellence of the hydrophilic surface areas are e.g. carbohydrates such as acid polysaccharides like gum arabic, carboxymethylcellulose, sodium alginate, propylene glycol ester of alginic acid, hydroxyethyl starch, dextrin, hydroxyethylcellulose, polyvinyl pyrrolidone, polystyrene sulphonic acid, polyvinyl alcohol and preferably polyglycols, being the reaction products of ethyleneoxide and/or propyleneoxide with water or an alcohol. Optionally, hygroscopic substances e.g. sorbitol, glycerol, tri(hydroxyethyl)ester of glycerol, and turkish red oil may be added.

A second embodiment of a lithographic printing plate which works according to the DTR mechanism is thus obtained.

Turning to the method for verifying the printing quality of silver-based lithographic printing plates as claimed by the present invention, it is to be understood that it is not intended to limit the invention to the preferred embodiments of silver-based lithographic printing plate precursors described above.

It is known in the art that the printing quality of silver-based lithographic printing plates is highly determined by the physical and chemical properties of the silver image that forms the printing areas of the plate, in particular the silver particles forming said image. The present invention discloses the hitherto unknown solution that the colour of the silver image can be used as a reliable indicator of the printing quality of a silver-based lithographic printing plate. A good printing quality is manifested by a number of features, such as a high printing endurance, low staining (ink-acceptance at the non-printing areas) and good inking-up quality (i.e. a low number of useless prints during start-up of the printing run due to poor ink-acceptance at the printing areas).

The colour of the silver image of the plate which is being matched with the colour reference system in the method according to the present invention is referred to hereinafter as "sample colour". The silver image colours which are contained in the colour reference system are referred to as "reference colours". Said reference colours are the silver image colours of a plurality of so-called "reference plates", which are each made with varying adjustments of the parameter(s) that influence(s) the plate-making process. In that way, a set of reference plates is obtained with different printing quality and different silver image colours, which can be used as reference colours. The printing quality of the reference plates is determined using the conventional quality measurement procedures. Reference is made to the examples, which give a description of the manufacturing process of a possible set of "reference plates" and their corresponding printing quality.

Once the correlation between the colour of the silver image of a silver-based lithographic printing plate and the corresponding printing quality is known, this correlation is used according to the present invention for verifying the printing quality of any sample plate of the same kind as the reference plates by matching the sample colour with the reference colours. Said match can be established in several ways, ranging from fully automatic colorimetry to visual comparison. Some possible methods are described hereinafter in more detail.

The most reliable colour matching methods rely on the quantification of colours in terms of device-independent colour data, such as the co-ordinates of the 1976 CIE (Commission Internationale de l'Eclairage) colour spaces (L*, u*,v*) or (L*,a*,b*) (the latter also called CIELAB colour space). These colour spaces are derived from the earlier 1931 CIE (x,y,z) colour space based on the so-called CIE Standard Observer Data obtained by averaging the results from investigations on colour matching by 17 non-colour-defective observers and on the relative luminance of the colours of the spectrum averaged for about a hundred observers. In the CIELAB colour space the co-ordinate L* represents the CIE lightness and the co-ordinates a* and b* relate to the 1976 CIE chroma C* and 1976 CIE hue-angle h according to the formulae $C^*=(a^{*2}+b^{*2})^{1/2}$ and $h=\arctan(b^*/a^*)$ .

The above mentioned matching step may be performed fully automatic by quantifying the sample colour and then comparing its co-ordinates with those of the reference colours that are stored in the colour reference system, which may e.g. be an electronic device such as a personal computer which is coupled to the colorimeter used to quantify the sample colour. Said comparison can be done by calculating the colour difference between the sample colour and each of the reference colours, the best matching reference colour being the one that has the lowest colour difference. Said colour difference is e.g. the 1976 CIELAB colour difference ΔE* defined by the following formula :

$$\Delta E^*=[(\Delta L^*)^2+(\Delta a^*)^2+(\Delta b^*)^2]^{1/2}$$

wherein each Δ is the difference of the colour co-ordinate of the sample colour and the reference colour.

In accordance with the above mentioned definition of chroma C* and hue-angle h, the above formula for calculating the colour difference can also be written as follows :

$$\Delta E^*=[(\Delta L^*)^2+(\Delta C^*)^2+(\Delta h)^2]^{½}$$

A more elegant though less accurate embodiment of the colour reference system used in the method according to the present invention, is a so-called "colour reference card", i.e. a hard copy which represents a plurality of reference colours. The best match between the sample colour and the reference colours on the card can be established simply by visual comparison. In a preferred embodiment, the reference colours are printed on the colour reference card by means of a colour management method using conversion tables to transform the device-independent colour co-ordinates of the reference colours into device dependent colour output signals, i.e. the CMYK values (Cyan, Magenta, Yellow and Black) of the particular printing device. Examples of such colour management methods are well known in the art and are used in many colour reproduction devices, such as displays, printers, copiers, etc. Most personal computer systems that need to reproduce colours accurately are set up with colour management software such as APPLE ColorSync® or AGFA FotoTune®. More details on this embodiment of the present invention using a colour reference card are given in the examples.

In another embodiment, the elegant solution of using a colour reference card is kept, but the accuracy of matching the sample colour with the reference colours on said card is increased by replacing the human observer by a colorimeter which determines the colour difference between the sample colour and each reference colour on said card in terms of device-independent data as described above. Other embodiments of colour reference systems that reproduce the reference colours accurately may be CRT's, LCD's or other colour image displays.

After establishing which reference colour best matches the sample colour, the user can predict the printing quality of the sample plate from the information provided by the colour reference system regarding the printing quality of a plate having such a sample colour. In a preferred embodiment, the colour reference system also provides information regarding the parameter(s) of the plate-making process that need(s) to be adjusted in order to improve the quality of the plates obtained by said process. The present invention thus also provides a process for making silver-based lithographic printing plates that can be optimized by using the verification methods described above.

EXAMPLES

Preparation of the silver halide emulsion coating solution

A silver chlorobromide emulsion composed of 98.2 molar% of chloride and 1.8 molar% of bromide was prepared by the double-jet precipitation method. The average silver halide grain size was 0.38 µm (diameter of a sphere with equivalent volume) and contained rhodium ions as internal dopant. The emulsion was ortho-chromatically sensitised and stabilised with a 1-phenyl-5-mercapto-tetrazole.

Preparation of the reference plate precursors

A polyethylene terephthalate film support having a thickness of 175 µm and being provided with a adhesion improving layer was coated with a layer containing gelatin in an amount of 0.4 g/$m^2$ and colloidal silica having an average particle diameter of 7 nm in an amount of 0.4 g/$m^2$. The adhesion improving layer contained a copolymer of itaconic acid (2%), vinylidene chloride (88%) and methylmethacrylate (10%). An emulsion prepared as described above was coated onto this polyethylene terephthalate film support together with an anti-halation layer such that the amount of gelatin was 2.8 g/$m^2$ in the anti-halation layer and 1.34 g/$m^2$ in the silver halide emulsion layer. The amount of silver halide expressed as $AgNO_3$ was 1.25 g/$m^2$ and the emulsion layer further contained developing agents, a silica matting agent and 150 mg/$m^2$ of formaldehyde as a hardener. The anti-halation layer further contained $BaSO_4$-particles having a size smaller than 800 nm (4 g/$m^2$) in combination with carbon black. The anti-halation layer was substantially free of matting agent. The thus obtained element was kept at 57°C at a relative humidity of 34% for 1 day. To this sample was then coated an image receiving layer of PdS nuclei prepared as described in EP-545,453. The coating solution of the image receiving layer contained an amount of synthetic clay (Laponite® RD, trade mark products of LAPORTE INDUSTRIES Limited, London) of 2 mg/$m^2$. This surface layer also contained 0.4 g/$m^2$ of hydroquinone and was substantially free of any hardening. The samples were then stored for 1 day at 57°C at a relative humidity of 34%.

Preparation of the treating solutions

The following alkaline processing liquid was prepared:

| | |
|---|---|
| sodium sulphite anhydrous | 35 g |
| EDTA, tetra-sodium salt | 1 g |
| 2-aminoethyl-aminoethanol | 45 ml |
| sodium hydroxide | 30 g |
| 1,4-dimethyl-5-(3-butenyl)-1,2,4-triazolium-3-thiolate | 0.8 g |
| 5-n.heptyl-2-mercapto-3,4-oxadiazole | 0.35 g |
| methylhydroquinone | 2 g |
| water to make | 1 litre |

The following neutralisation liquid was prepared:

| | |
|---|---|
| Synperonic® PE-L35 (a) | 200 mg |
| tri-ethanolamine | 10 ml |
| sodium sulphite anhydrous | 4 g |
| 1-($\alpha$-(N,N-dibutyl)acetylamide)-5-mercapto-1,2,3,4-tetrazole | 800 mg |
| EDTA, tetra-sodium salt | 1 g |
| sodium benzoate | 1 g |
| Turpinal® 2NZ (b) | 1 g |
| sodiumdihydrogen phosphate | 1.1 g |
| potassiumdihydrogen phosphate | 38.3 g |
| citric acid | 5.4 g |
| sodium hydroxide | 1.05 g |
| water to make | 1 litre |
| pH was adjusted to 5.9 | |

(a) Synperonic PE-L35 is a non-ionic surfactant, trade name of ICI.
(b) Turpinal 2NZ is a trade name of HENKEL, Belgium for 1-hydroxy-ethylidene-diphosphonic acid, disodium salt.

The following dampening liquid was prepared:

| | |
|---|---|
| water | 880 ml |
| citric acid | 6 g |
| boric acid | 8.4 g |
| sodium sulphate, anhydrous | 25 g |
| ethyleneglycol | 100 g |
| colloidal silica | 28 g |

Preparation of the reference plates and test results

The material obtained was divided into five samples and each sample was used as a precursor to prepare a reference printing plate by image-wise exposing and processing with the alkaline processing liquid and neutralisation liquid described above, then rinsed with water and dried. Plate no. 1 was made with optimal settings of all parameters of the plate-making process. The other plates were made by adjusting a parameter of the plate-making process as indicated in Table 1 so as to obtain five reference plates with different printing quality and different silver image colour. Unless otherwise indicated, the printing plate precursor materials were kept at normal atmospheric conditions before plate-making and fresh processing liquids were used at a processing temperature of 30°C. Plate no. 2 was made by processing at too low a temperature (18°C). Plate no. 3 was made identically as plate no. 1 but stored after processing during 10 days at 35°C and 80% relative humidity. Plate precursor no. 4 was pre-fogged before exposure so that part of its silver content can not diffuse to the image receiving layer and then processed as plate no. 1. Plate no. 5 was obtained by processing with liquids that were exhausted with at least 10 $m^2$ of precursor.

In order to evaluate the printing quality, the reference plates were mounted on a AB DICK 9860 offset printing machine (trade name of AB DICK Co.). During the printing run, AB DICK 1020 black ink was applied onto the plates

together with a fountain solution obtained by diluting the dampening liquid described above to an amount of 5% by volume. The "inking-up" quality of the reference plates was evaluated by counting the number of copies that had to be disposed of before a steady, perfect black print could be obtained. The printing endurance was evaluated as the number of printed copies obtained before occurrence of loss of small details on the copy. The test results are listed in Table 1. The printing endurance of plate no.2 could not be established due to its inferior inking-up quality.

Table 1 also indicates the visual perception by a human observer of the silver image colour at the printing areas of the reference plates. These reference colours were quantified in CIELAB co-ordinates by means of a GRETAG SPM-50 colorimeter analysing the reflectance spectrum at an angle of 45°. A colour reference card was made as described above by transforming said CIELAB co-ordinates to device-specific CMYK values of a TEKTRONIX 440 Phaser® colour printer (values listed in Table 1) and then printing the five reference colours next to the plate-making parameter which was responsible for the silver colour obtained (as given in the first column of Table 1). The colour reference card thus obtained can now be used for determining the printing quality of similar silver-based lithographic printing plates as the reference plates described above and for optimising the plate-making process.

Having described in detail preferred embodiments, it will now be apparent to those skilled in the art that numerous modifications can be made without departing from the scope of the present invention. As an example, also an unexposed or partially exposed plate may be used as test plate for verifying the quality of the plate-making process. Such an unexposed area of a plate does not contain a silver "image" in the literal sense but is ink-receptive over the whole unexposed area. It shall be understood that matching the silver colour of said unexposed area with a colour reference system for verifying the printing quality of the plate is considered to be equivalent to the method of the present invention and is covered by the scope of the following claims.

Table 1

| Plate No. | Plate-making parameter | Printing endurance | Inking-up | Silver colour | L* | a* | b* | C | M | Y | K |
|---|---|---|---|---|---|---|---|---|---|---|---|
| 1 | All parameters optimal | >15,000 | <10 | blue | 58 | -2.4 | -5.8 | 28 | 3 | 10 | 44 |
| 2 | Processing temperature 18°C | - | >100 | yellowish | 62 | -3.8 | -0.1 | 20 | 2 | 15 | 41 |
| 3 | Plate stored 10 days at 35°C/85%R.H. | <2000 | <10 | gray | 59 | -1.5 | -2.1 | 19 | 5 | 12 | 45 |
| 4 | Plate precursor pre-fogged | <2000 | <10 | gray | 60 | -1.6 | -3.5 | 22 | 4 | 11 | 43 |
| 5 | Chemistry exhausted | <5000 | ± 25 | yellowish | 57 | -3.0 | +1.2 | 16 | 4 | 15 | 50 |

**Claims**

1. A method for verifying the printing quality of a lithographic printing plate which is obtained by a plate-making process whereby an ink-receptive silver image is formed at the printing areas, characterised in that said method comprises the step of matching the colour of the silver image of said plate with a plurality of reference colours contained in a colour reference system that provides information regarding the printing quality of silver-based lithographic printing plates having said reference colours.

2. A method according to claim 1 wherein the colour reference system also provides information regarding the parameter(s) of the plate-making process that need(s) to be adjusted in order to optimize the printing quality of the plate obtained by said plate-making process.

3. A method according to claim 1 or 2 wherein the plate-making process is the silver salt diffusion transfer reversal process, using a lithographic printing plate precursor comprising a support, a light-sensitive layer containing silver halide crystals and an image receiving layer containing physical development nuclei.

4. A method according to any of claims 1 to 3 wherein the colour reference system is a colour reference card representing a plurality of reference colours and the step of matching the colour of the silver image of the plate with a plurality of reference colours is performed by visual comparison with the reference colours on said colour reference card.

5. A method for making a colour reference system for use in a method as defined in any of the previous claims comprising the step of quantifying the silver image colour of a plurality of reference plates in terms of device-independent colour data.

6. A method according to claim 5 wherein the colour reference system is a system reproducing a plurality of reference colours accurately by means of a colour output device of which the output signals are obtained by transforming the device-independent colour data of the reference colours into device-specific colour data of said output device.

7. A method according to claim 6 wherein the colour reference system is a colour reference card representing a plurality of reference colours, said reference colours being printed on said card by a colour printing device of which the CMYK values are obtained by transforming the device-independent colour data of the reference colours into device-specific colour data of said printing device.

8. A method according to any of claims 1 to 4 wherein the colour reference system is obtained by the method defined in any of claims 5 to 7.

9. A method according to claim 8 wherein the step of matching the colour of the silver image of the plate with a plurality of reference colours is performed by quantifying the colour of the silver image of said plate in terms of device-independent colour co-ordinates and determining the colour difference between the device-independent colour co-ordinates of said plate and the ones of the reference colours contained in the colour reference system.

10. A plate-making process process for making a silver-based lithographic printing plate from a plate precursor comprising the steps of

    (i) forming a silver image at the printing areas by treating the plate precursor with a processing liquid;
    (ii) verifying the printing quality of the plate thus obtained by a verification method as defined in any of claims 1 to 4, 8 and 9;
    (iii) if necessary, adjusting a parameter of the plate-making process according to the information provided by the verification method so as to optimize the printing quality of the plate obtained by the plate-making process.

**Patentansprüche**

1. Ein Verfahren zur Überprüfung der Druckqualität einer lithografischen Druckplatte, die nach einem Druckplattenherstellungsverfahren erhalten ist, bei dem in den druckenden Bereichen ein farbanziehendes Silberbild erhalten wird, dadurch gekennzeichnet, daß bei diesem Verfahren die Silberbildfarbe der Druckplatte mit einer Vielzahl von in einem Farbreferenzsystem enthaltenen Referenzfarben verglichen wird, wobei das Referenzsystem Angaben

über die Druckqualität von auf Silber basierenden lithografischen, diese Referenzfarben aufweisenden Druckplatten verschafft.

2. Verfahren nach Anspruch 1, dadurch gekennzeichnet, daß das Farbreferenzsystem ebenfalls Information über den (die) Parameter des Plattenherstellungsverfahrens verschafft, der (die) angepaßt werden muß (müssen), um die Druckqualität der nach dem Plattenherstellungsverfahren erhaltenen Druckplatte zu optimieren.

3. Verfahren nach Anspruch 1 oder 2, dadurch gekennzeichnet, daß das Plattenherstellungsverfahren das Silbersalz-Diffusionsübertragungs-Umkehrverfahren ist, bei dem ein lithografischer Druckplattenvorläufer benutzt wird, der einen Träger, eine lichtempfindliche, Silberhalogenidkristalle enthaltende Schicht und eine physikalische Entwicklungskeime enthaltende Bildempfangsschicht enthält.

4. Verfahren nach irgendeinem der Ansprüche 1 bis 3, dadurch gekennzeichnet, daß das Farbreferenzsystem eine Farbreferenzkarte ist, die eine Vielzahl von Referenzfarben enthält, und die Stufe der Ermittlung der Übereinstimmung zwischen der Silberbildfarbe der Druckplatte und einer Vielzahl von Referenzfarben durch visuellen Vergleich mit den Referenzfarben auf der Farbreferenzkarte erledigt wird.

5. Verfahren zur Herstellung eines Farbreferenzsystems zum Einsatz in einem wie in irgendeinem der vorstehenden Ansprüche definierten Verfahren, wobei die Silberbildfarbe einer Vielzahl von Referenzplatten in bezug auf geräteunabhängige Farbdaten quantifiziert wird.

6. Verfahren nach Anspruch 5, dadurch gekennzeichnet, daß das Farbreferenzsystem ein System ist, bei dem eine Vielzahl von Referenzfarben mittels einer Farbausgabevorrichtung, in der die Ausgabesignale durch Umwandlung der geräteunabhängigen Farbdaten der Referenzfarben in geräteabhängige Farbdaten der Farbausgabevorrichtung erhalten werden, präzise reproduziert wird.

7. Verfahren nach Anspruch 6, dadurch gekennzeichnet, daß das Farbreferenzsystem eine Farbreferenzkarte mit einer Vielzahl von Referenzfarben ist, die mittels eines Farbdruckers, dessen CMYK-Werte durch Umwandlung der geräteunabhängigen Farbdaten der Referenzfarben in geräteabhängige Farbdaten des Druckers erhalten werden, auf der Karte gedruckt werden.

8. Verfahren nach irgendeinem der Ansprüche 1 bis 4, dadurch gekennzeichnet, daß das Farbreferenzsystem nach dem in irgendeinem der Ansprüche 5 bis 7 definierten Verfahren erhalten wird.

9. Verfahren nach Anspruch 8, dadurch gekennzeichnet, daß die Stufe der Ermittlung der Übereinstimmung zwischen der Silberbildfarbe der Druckplatte und einer Vielzahl von Referenzfarben durch Quantifizierung der Silberbildfarbe der Druckplatte in bezug auf ceräteunabhängige Farbkoordinaten und Ermittlung der Farbdifferenz zwischen den geräteunabhängigen Farbkoordinaten der Druckplatte und denen der im Farbreferenzsystem enthaltenen Referenzfarben erledigt wird.

10. Plattenherstellungsverfahren zur Herstellung einer auf Silber basierenden lithografischen Druckplatte aus einem Plattenvorläufer, das folgende Stufen umfaßt :

(i) Erzeugung eines Silberbildes in den druckenden Bereichen durch Verarbeitung des Plattenvorläufers mit einer Verarbeitungsflüssigkeit,
(ii) Überprüfung der Druckqualität der so erhaltenen Druckplatte nach einem wie in irgendeinem der Ansprüche 1 bis 4, 8 und 9 definierten Überprüfungsverfahren, und
(iii) nötigenfalls das Anpassen eines Parameters des Plattenherstellungsverfahrens in Übereinstimmung mit der durch das Überprüfungsverfahren verschafften Information, um die Druckqualität der nach dem Plattenherstellungsverfahren erhaltenen Druckplatte zu optimieren.

## Revendications

1. Procédé pour vérifier la qualité d'impression d'un cliché d'impression lithographique que l'on obtient via un procédé de fabrication de clichés par lequel on forme une image argentique amoureuse de l'encre dans les zones d'impression, caractérisé en ce que ledit procédé comprend l'étape consistant à mettre en correspondance la couleur de l'image argentique dudit cliché avec plusieurs couleurs de référence contenues dans un système de référence

de couleurs qui fournit des informations en ce qui concerne la qualité d'impression de clichés d'impression lithographiques à base d'argent possédant lesdites couleurs de référence.

2. Procédé selon la revendication 1, dans lequel le système de référence de couleurs fournit également des informations en ce qui concerne le ou les paramètres du procédé de fabrication de cliché qui doit ou doivent être réglé (s) dans le but d'optimiser la qualité d'impression du cliché obtenu via ledit procédé de fabrication de cliché.

3. Procédé selon la revendication 1 ou 2, dans lequel le procédé de fabrication de cliché est le procédé d'inversion-transfert par diffusion de sels d'argent dans lequel on utilise un précurseur de cliché d'impression lithographique comprenant un support, une couche photosensible contenant des cristaux d'halogénure d'argent et une couche de réception d'image contenant des germes de développement physique.

4. Procédé selon les revendications 1 à 3, dans lequel le système de référence de couleurs est une carte de référence de couleurs représentant plusieurs couleurs de référence, et l'étape consistant à mettre en correspondance la couleur de l'image argentique du cliché avec plusieurs couleurs de référence est mise en oeuvre par comparaison à l'oeil nu avec les couleurs de référence sur ladite carte de référence de couleurs.

5. Procédé pour préparer un système de référence de couleurs à utiliser dans un procédé tel que défini dans l'une quelconque des revendications précédentes, comprenant l'étape consistant à quantifier la couleur de l'image argentique de plusieurs clichés de référence en termes de données de couleurs indépendantes du dispositif.

6. Procédé selon la revendication 5, dans lequel le système de référence de couleurs est un système reproduisant plusieurs couleurs de référence de manière précise à l'aide d'un dispositif de sortie de couleurs à partir duquel on obtient les signaux de sortie en transformant les données des couleurs de référence indépendantes du dispositif en données de couleurs spécifiques audit dispositif de sortie.

7. Procédé selon la revendication 6, dans lequel le système de référence de couleurs est une carte de référence de couleurs représentant plusieurs couleurs de référence, lesdites couleurs de référence étant imprimées sur ladite carte via un dispositif d'impression de couleurs à partir duquel on obtient les valeurs CMYK en transformant les données des couleurs de référence indépendantes du dispositif en données de couleurs spécifiques audit dispositif de sortie.

8. Procédé selon l'une quelconque des revendications 1 à 4, dans lequel on obtient le système de référence de couleurs via le procédé défini dans l'une quelconque des revendications 5 à 7.

9. Procédé selon la revendication 8, dans lequel l'étape consistant à mettre en correspondance la couleur de l'image argentique du cliché avec plusieurs couleurs de référence est mise en oeuvre en quantifiant la couleur de l'image argentique dudit cliché en termes de coordonnées de couleurs indépendantes du dispositif et en déterminant la différence de couleur entre les coordonnées de couleurs dudit cliché indépendantes du dispositif et celles des couleurs de référence contenues dans le système de référence de couleurs.

10. Procédé de fabrication de clichés pour fabriquer un cliché d'impression lithographique à base d'argent à partir d'un précurseur de cliché comprenant les étapes consistant à:

(i) former une image argentique dans les zones d'impression en traitant le précurseur de cliché avec un liquide de traitement;
(ii) vérifier la qualité d'impression du cliché ainsi obtenu via un procédé de vérification tel que défini dans l'une quelconque des revendications 1 à 4, 8 et 9;
(iii) si nécessaire, régler un paramètre du procédé de fabrication de clichés conformément aux informations obtenues par le procédé de vérification de façon à optimiser la qualité d'impression du cliche obtenu par le procédé de fabrication de clichés.